# EUROPEAN PATENT SPECIFICATION

(11) **EP 3 897 088 B1**
(45) Date of publication and mention of the grant of the patent: **14.01.2026**
(21) Application number: 18942948.3
(22) Date of filing: 14.12.2018
(51) Int. Cl.: H05K 13/08

(54) **COMPONENT COLLECTING DEVICE AND COMPONENT MOUNTING MACHINE**
KOMPONENTENRÜCKGEWINNUNGSVORRICHTUNG UND KOMPONENTENMONTAGEMASCHINE
DISPOSITIF DE RÉCUPÉRATION DE COMPOSANT ET MACHINE DE MONTAGE DE COMPOSANT

(43) Date of publication of application: 20.10.2021
(73) Proprietor: Fuji Corporation, Chiryu-shi, Aichi 472-8686 (JP)
(72) Inventor: SUGIYAMA Hiroshi, Chiryu-shi, Aichi 472-8686 (JP); MIZUNO Takayuki, Chiryu-shi, Aichi 472-8686 (JP); KAGOSHIMA Hiroyuki, Chiryu-shi, Aichi 472-8686 (JP); SATO Yosuke, Chiryu-shi, Aichi 472-8686 (JP)
(74) Representative: Grünecker Patent- und Rechtsanwälte PartG mbB
(86) International application number: PCT/JP2018/046205
(87) International publication number: WO 2020/121535

(56) References cited:
- WO-A1-2017/212548
- WO-A1-2017/212548
- JP-A- 2006 165 432
- JP-A- 2006 196 824
- JP-A- 2007 220 754
- JP-A- 2007 329 269
- JP-A- 2008 085 067
- JP-A- 2012 156 463
- JP-A- 2015 230 203

## Description

### Technical Field

The present specification relates to a component collecting device and a component mounting machine provided with the component collecting device.

### Background Art

Technology for mass-producing board products by performing board work on a board on which printed wiring is performed has become widespread. A typical example of a board work machine for executing board work is a component mounting machine for executing a mounting operation of a component. As the component mounting machine performs mounting work, an unsuitable component determined to be unsuitable for the mounting operation occurs. A component collecting box is provided to collect the unsuitable component. The collected unsuitable component is discarded if the unsuitable component is inexpensive, and the quality is checked by visual inspection or the like if the unsuitable component is expensive. The unsuitability determination is canceled for the expensive component that has been confirmed as a good component and is provided to the mounting operation again.

The typical component collecting box does not have a function of detecting full capacity and does not have a mechanism for automatically removing collected unsuitable components. Therefore, avoiding full capacity is left to the daily maintenance work of an operator. If the component collecting box becomes full, a failure in which overflowing unsuitable components are scattered, or a failure in which a suction nozzle, a chuck, or the like interferes with stacked unsuitable components may occur. An example of technology related to this type of component collecting box is disclosed in JP 2016 18910 A.

The component collecting device of JP 2016 18910 A has a collecting container for collecting unsuitable components at a component discarding position, and a moving mechanism and a control unit for moving the collecting container from the component discarding position to the component collecting position. With this configuration, the collecting container is moved to the component collecting position and the operator can remove the unsuitable component even while the component mounting machine is in operation. Further, JP 2016 18910 A discloses the calculation of the number of unsuitable components and the use of a weight sensor to detect the discarding state of the unsuitable component. WO 2017/212548 A1 discloses a component mounting machine with a collecting box in which a light blocking detection sensor detects that the level of discarded components has reached the level of the sensor.

### Summary of the Invention

### Technical Problem

In JP 2016 18910 A, full capacity of the collecting container is detected by calculating the number of unsuitable components or detecting the total weight of unsuitable components, but it cannot be said that adequate detection accuracy is necessarily obtained. That is, even if the estimated size of the space occupied by the unsuitable component can be obtained from the number or total weight of unsuitable components, it is difficult to reliably detect whether the collecting container is close to full.

In addition, in a event of unsuitable component straddling over the opening of the collecting container, the actual opening becomes small, and this makes it difficult to collect unsuitable components, even when inside of the collecting container has enough space. Such a state, in which the actual opening is small, cannot be detected by the number or total weight of unsuitable components. In a case that the size of the collecting container is increased in order to solve this problem, restriction of the arrangement is placed on the devices in the machine and, in some cases, this affects the size of the component mounting machine.

It is an object of the present specification to provide a component collecting device configured to reliably detect a state in which a collecting container is close to full capacity or an unsuitable component is straddling over the opening of the collecting container, and a component mounting machine provided with the component collecting device.

### Solution to Problem

The present specification discloses a component collecting device according to appended claim 1.

In addition, the present specification discloses a component mounting machine according to appended claim 3, comprising the component collecting device according to appended claim 1.

### Advantageous Effect of the Invention

In the component collecting device or the component mounting machine disclosed in the present specification, a collecting state detector spatially detects the collecting state of unsuitable components collected in the collecting container. In this manner, a state close to full capacity in which the empty space in the collecting container has become small and a state in which an unsuitable component is straddling over the opening of the collecting container are reliably detected.

### Brief Description of Drawings

Fig. 1 is a plan view schematically showing the entire configuration of a component mounting machine of a first embodiment.
Fig. 2 is a perspective view of a component collecting device of the first embodiment.
Fig. 3 is a plan view of the component collecting device.
Fig. 4 is a cross-sectional side view of the upper portion of the component collecting device.
Fig. 5 is a block diagram showing a control configuration of the component mounting machine.
Fig. 6 is a control flowchart of a control device, showing operations of the component mounting machine and the component collecting device.
Fig. 7 is a perspective view showing the collection of a large unsuitable component.
Fig. 8 is a control flowchart of a control device, showing the collecting operation of unsuitable components in a component mounting machine of a second embodiment.
Fig. 9 is a perspective view showing the collection of a large unsuitable component in the second embodiment.

### Description of Embodiments

### 1. Overall configuration of component mounting machine 1

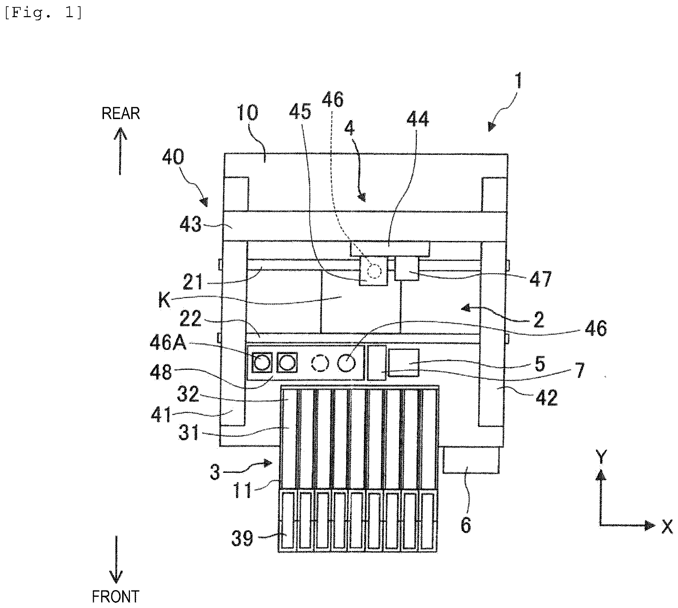

First, of component collecting device 7 and component mounting machine 1 of a first embodiment, the entire configuration of component mounting machine 1 will be described with reference to Fig. 1. Component mounting machine 1 executes a mounting operation for mounting a component on board K. The direction from the left side to the right side of the drawing in Fig. 1 is the X-axis direction for conveying board K, and the direction from the lower side (front side) to the upper side (rear side) of the drawing is the Y-axis direction. Component mounting machine 1 is configured by assembling board conveyance device 2, multiple feeders 3, component transfer device 4, component camera 5, control device 6, a component collecting device 7, and the like to base 10.

Board conveyance device 2 includes a pair of guide rails 21, 22, a pair of conveyor belts, a board clamping mechanism, and the like. The conveyor belts convey in board K to the work execution position by rotating along guide rails 21, 22 with board K placed on the conveyor belts. The board clamping mechanism pushes up board K at the work execution position to clamp and position board K. When the mounting operation of the component is finished, the board clamping mechanism releases board K. Subsequently, the conveyor belts convey board K out.

Feeders 3 are detachably installed in multiple groove-shaped slots provided in pallet member 11 on base 10. In each feeder 3, tape reel 39 is loaded from the front side of main body section 31. Supply position 32 for supplying components is set at the top portion in vicinity of the rear side of main body section 31. A carrier tape, in which components are accommodated in multiple cavities, is wound around tape reel 39. Feeder 3 feeds the carrier tape to supply position 32 by a tape feeding mechanism (not shown). As a result, feeder 3 sequentially performs a supply operation that allows components to be extracted from the cavities. A tray device for mainly supplying large-sized components using a tray may be provided instead of a portion or all of feeders 3.

Component transfer device 4 is equivalent to a mounting executing device. Component transfer device 4 is disposed above board conveyance device 2 and feeder 3. Component transfer device 4 picks up a component from feeder 3, transfers the component, and releases the component to mount the component on board K. Component transfer device 4 has head driving mechanism 40, mounting head 45, nozzle tool 46, chuck tool 46A, mark camera 47, and the like.

Head driving mechanism 40 is configured to include a pair of Y-axis rails 41, 42, Y-axis slider 43, and a drive motor (not shown). Y-axis rails 41, 42 extend in the Y-axis direction parallel to each other and are spaced apart from each other. Y-axis slider 43 extending in the X-axis direction is mounted so as to straddle both Y-axis rails 41, 42 and moves in the Y-axis direction. Moving base 44 is mounted on Y-axis slider 43 and moves in the X-axis direction. Head driving mechanism 40 drives Y-axis slider 43 in the Y-axis direction and drives moving base 44 on Y-axis slider 43 in the X-axis direction.

Moving base 44 holds mounting head 45 and mark camera 47. Mark camera 47 captures an image of a position mark attached to the positioned board K and detects the work execution position of board K. Nozzle tool 46 or chuck tool 46A is provided on the lower side of mounting head 45. Multiple types of nozzle tools 46 and chuck tools 46A are automatically exchanged. In Fig. 1, nozzle tool 46 is provided on mounting head 45. Nozzle tool 46 has one or multiple suction nozzles (not shown) on its lower side.

The suction nozzle is operated to move up and down by being driven by a lifting and lowering drive section (not shown). The suction nozzle moves downward from above supply position 32, performs a suction operation by supplying negative pressure, and picks up the component. In addition, the suction nozzle is driven to a position above board K and releases the component by supplying positive pressure to execute a mounting operation. The suction nozzle is intended mainly for small and medium-sized components, for example, chip components. Small and medium-sized components are often inexpensive. Therefore, small and medium-sized components are discarded when it is determined that they are not suitable for the mounting operation.

Chuck tool 46A has a chuck (not shown) on the lower side. The chuck opens and closes to clamp and release the component. The chuck is intended primarily for large components such as LSI components (e.g., CPU). Large components are often expensive. Therefore, even if it is determined that the large component is not suitable for the mounting operation, the component is not discarded immediately, and it is determined whether the component can be used by checking whether it is good by visual inspection or the like.

**In** order to automatically exchange nozzle tool 46 and chuck tool 46A, tool station 48 is provided on the upper face of base 10 between board conveyance device 2 and feeder 3. Nozzle tools 46 and chuck tools 46A for exchanging are arranged in tool station 48. Instead of the automatic exchanging of a tool, the automatic exchanging of the entire mounting head 45 or the automatic exchanging of only the suction nozzle and the chuck may be performed. **In** addition, for a configuration without tool station 48, manual exchange may be performed.

Component camera 5 is provided on the top face of base 10, between board conveyance device 2 and feeder 3, and faces upward. Component camera 5 captures an image of the component held by the suction nozzle or the chuck while mounting head 45 is on the way from feeder 3 to board K. The acquired image data is subjected to image processing, and the shape and orientation of the component are acquired as a result of the image processing. Based on the image processing result, it is determined whether the component is suitable for the mounting operation.

For example, when damage occurs on a component and the outer shape is deformed, or when an abnormality is observed in the shape of the leads, the component is determined to be an unsuitable component unsuitable for the mounting operation. In this case, it is difficult to repair and use the unsuitable component and the unsuitable component is often discarded.

Further, when the center position of the component is greatly displaced with respect to the suction nozzle or the chuck or the orientation of the component is tilted, the component is determined to be an unsuitable component due to the difficulty of the mounting operation in these cases. Further, the component is determined to be an unsuitable component in the same manner when the up-down direction of the component is reversed, or, for a component having a polarity, when the left and right or the front and rear are incorrect. In these cases, even if the component is determined to be an unsuitable component, the component itself does not have an abnormality. Accordingly, there is a possibility that it can be used for a retry operation, a manual mounting operation, or the like. Operational feasibility is checked for large and expensive components. On the other hand, inexpensive components are discarded regardless of the presence or absence of abnormality, so such efforts are omitted.

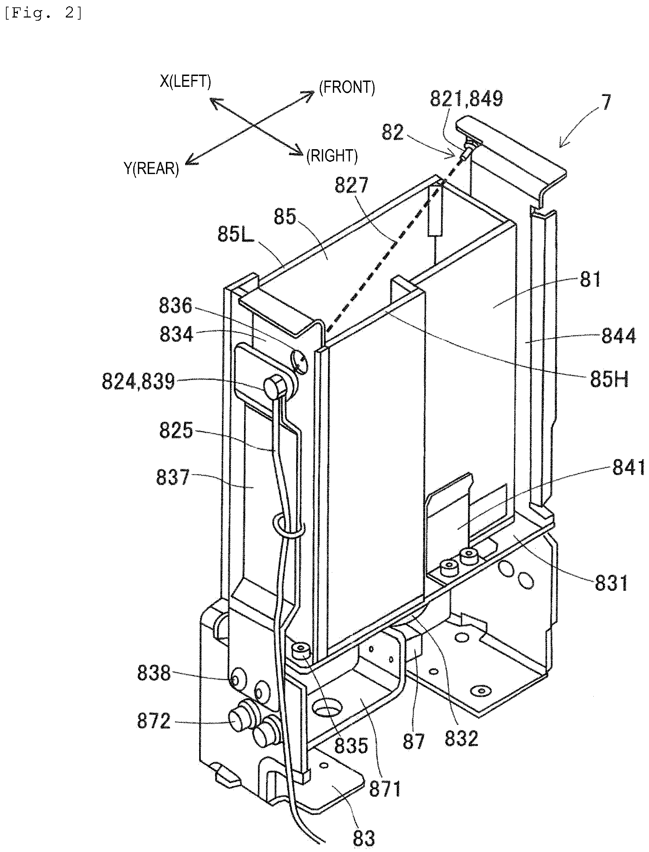

Control device 6 is assembled to base 10, and the arrangement position of control device 6 is not particularly limited. Control device 6 is configured with a computer device having a CPU and operated with software. It should be noted that control device 6 may be configured such that multiple CPUs are distributed in the machine. Control device 6 controls the execution of the mounting operation in accordance with the mounting sequence stored in advance. The mounting sequence differs depending on the type of board product to be manufactured. In addition, control device 6 performs control so as to cause component transfer device 4 to perform a collecting operation for collecting unsuitable components in collecting container 81 (see Fig. 2).

### 2. Configuration of component collecting device 7

Component collecting device 7 of the first embodiment is disposed between tool station 48 and component camera 5 on base 10. The configuration of component collecting device 7 will be described in detail with reference to Figs. 2 to 4. As shown in the perspective view of Fig. 2, component collecting device 7 has collecting container 81, collecting state detection section 82, receiving member 83, container detection sensor 87, and the like. In order to simplify the following descriptions, the front-rear and left-right directions shown in Fig. 2 will be used for convenience.

Receiving member 83 is provided on the top face of base 10. Receiving member 83 is formed by bending or cutting a plate material made of metal or formed by resin molding or the like. Receiving member 83 has bottom receiving section 831, rear plate 834, rear sensor support plate 837, side face receiving portion 841, front plate 844, and front sensor support plate 847.

Bottom receiving section 831 is a section for receiving the bottom face of collection container 81 and extends horizontally in the front-rear direction in proximity to base 10. The top side of bottom receiving section 831 serves as a set space for setting collecting container 81. Bottom receiving section 831 has recessed portion 832 recessed downward. Collecting container 81 has a protrusion (not shown) protruding downward from the bottom face thereof. When the protrusion is fitted into recessed portion 832, collecting container 81 is set to a set position.

Container detection sensor 87 is provided at a position facing recessed portion 832 of bottom receiving section 831. Container detection sensor 87 is supported by the rear side of receiving member 83 via plate member 871 and two screws 872. Container detection sensor 87 detects whether the protrusion of collecting container 81 is fitted into recessed portion 832. The sensing signal of container detection sensor 87 is outputted to control device 6. If the detection signal is not received, control device 6 determines that collecting container 81 is not set.

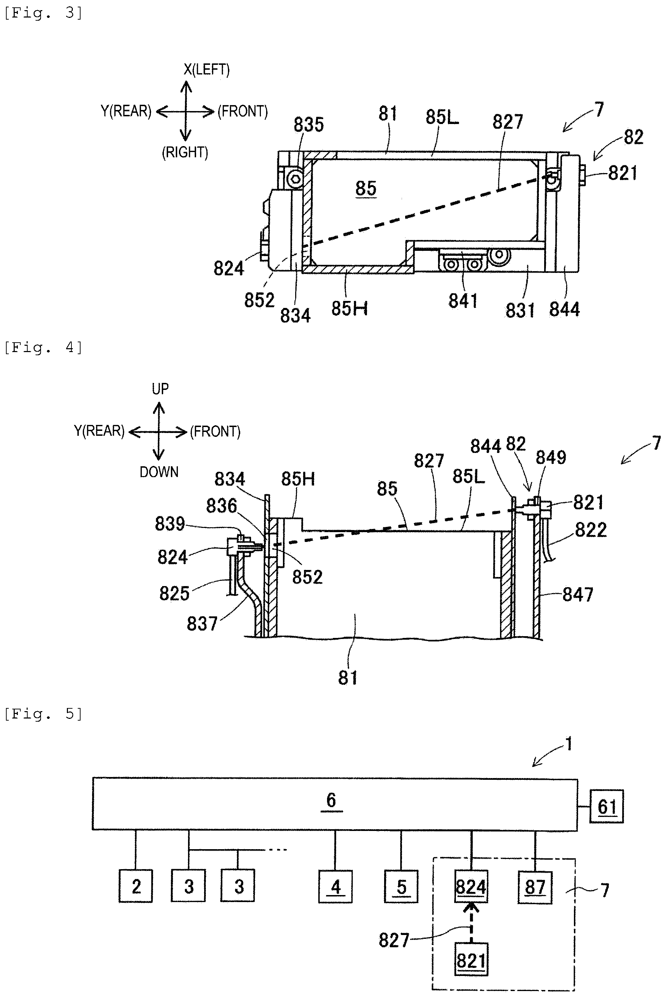

Rear plate 834 is a member separate from receiving member 83 and is disposed vertically. Rear plate 834 is fixed to the rear of the top face of bottom receiving section 831 with two screws 835. The height of rear plate 834 is slightly higher than the set collecting container 81 (see Fig. 4). The plate width of rear plate 834 in the left-right direction is smaller than the width of collecting container 81. Light passage hole 836 is provided on the right side toward the top of rear plate 834.

Rear sensor support plate 837 is a member separate from receiving member 83 and is disposed vertically behind rear plate 834. Rear sensor support plate 837 is fixed to the rear face of receiving member 83 with two screws 838. The height of rear sensor support plate 837 is slightly lower than the height of rear plate 834 (see Fig. 4). Rear sensor seat 839 is provided on the right side toward the top of rear sensor support plate 837. Rear sensor seat 839 is an attachment hole, and is not limited to this. Rear sensor seat 839 is located behind light passage hole 836. Rear sensor seat 839 and light passage hole 836 are located lower than low peripheral edge portion 85L of the set collecting container 81 (see Fig. 4).

Side face receiving portion 841 receives the right side face of collecting container 81. Side face receiving portion 841 is disposed vertically on the right side of the top face of bottom receiving section 831. Front plate 844 is a member separate from receiving member 83 and is disposed vertically. Front plate 844 is fixed to the front portion of the top face of bottom receiving section 831 with two screws. The height of front plate 844 is equal to the height of rear plate 834 (see Fig. 4). The plate width of front plate 844 in the left-right direction is smaller than the width of collecting container 81.

Front sensor support plate 847 is a member separate from receiving member 83 and is disposed vertically in front of front plate 844. Front sensor support plate 847 is fixed to the front face of receiving member 83 with two screws. The height of front sensor support plate 847 approximately coincides with the height of front plate 844 (see Fig. 4). Front sensor seat 849 is provided on the left side toward the top of front sensor support plate 847. Front sensor seat 849 is configured to be an attachment hole similar to rear sensor seat 839. Front sensor seat 849 is located higher than high peripheral edge portion 85H of the set collecting container 81 (see Fig. 4) and is located to the left of the left edge of front plate 844.

Collecting container 81 is a container for collecting unsuitable components determined to be unsuitable for the mounting operation. Collecting container 81 has a box shape having opening 85 opened upward and is elongated in the front-rear direction. Collecting container 81 is formed by bonding multiple resin plates. In order to avoid interferences with the tool exchanging operation at tool station 48, the width of collecting container 81 in the left-right direction is small at the front and large at the rear. Light passage hole 852 is provided in the upper portion of the rear side of collecting container 81. Light passage hole 852 of collecting container 81 is located in front of light passage hole 836 of rear plate 834.

Collecting container 81 is not limited to the above-described configuration and may be, for example, a resin molded article or a metal molded article, or may be formed in a rectangular parallelepiped shape. The protrusion described above is provided on the lower side of collecting container 81. Collecting container 81 is set in a set space defined by bottom receiving section 831, rear plate 834, and front plate 844 of receiving member 83 and is positioned by the protrusion.

Collecting container 81 has different heights at different portions of the peripheral edge of opening 85. Specifically, the rear and the portion at the right side of collecting container 81, indicated by hatching in Fig. 3 for convenience, are high peripheral edge portion 85H. The portion of the right side other than high peripheral edge portion 85H, the front, and the left peripheral edge portion are low peripheral edge portion 85L. The reason why high peripheral edge portion 85H and low peripheral edge portion 85L are provided is to ensure detection with collecting state detection section 82 of large unsuitable components that straddle across in an inclined orientation.

Collecting state detection section 82 spatially detects the collecting state of unsuitable components collected in collecting container 81. In addition, collecting state detection section 82 detects the state in which collecting container 81 is nearly full capacity with unsuitable components or a large unsuitable component straddling across opening 85. In the first embodiment, collecting state detection section 82 employs a light-blocking detection sensor configured to include light-emitting portion 821 and light-receiving portion 824. Light-emitting portion 821 is disposed in front sensor seat 849 corresponding to one position in the vicinity of opening 85. Light-receiving portion 824 is disposed in rear sensor seat 839 corresponding to another position in the vicinity of opening 85.

Light-emitting portion 821 is supplied with power from power source line 822 throughout the time period during which component mounting machine 1 is operating and emits detection light 827 passing through opening 85. The optical axis of detection light 827 is inclined in the length direction, the width direction, and the height direction of collecting container 81, as indicated by a thick dashed line in Figs. 2 to 4. Specifically, the optical axis of detection light 827 is directed obliquely downward in the rear-right direction from light-emitting portion 821 and passes through the left side of front plate 844. Further, the optical axis of detection light 827 passes through opening 85, passes through light passage hole 852 of collecting container 81 and light passage hole 836 of rear plate 834 and reaches light-receiving portion 824.

Light-receiving portion 824 detects by distinguishing between a light-receiving state, in which detection light 827 is received, and a light-blocking state, in which detection light 827 is blocked. In this way, light-receiving portion 824 can detect a light-blocking state in which collecting container 81 is nearly full capacity causing detection light 827 to be blocked by an unsuitable component. Light-receiving portion 824 is connected to control device 6 via output line 825 and outputs a detection signal to control device 6.

The positions of light-emitting portion 821 and light-receiving portion 824 may be exchanged. Further, the objective for inclining the optical axis of detection light 827 is to reliably detect light that is incident on a large unsuitable component straddling across opening 85 from an oblique direction. In this way, in accordance with this purpose, the inclination direction of the optical axis of detection light 827 may be appropriately changed. For example, the optical axis of detection light 827 may be inclined so as not to be inclined in the width direction (i.e., the left-right direction) of collecting container 81 but only fall directly downward from the front to the rear.

Next, a control configuration of component mounting machine 1 will be described with reference to Fig. 5. As shown in the figure, control device 6 is communicatively connected to board conveyance device 2, feeders 3, component transfer device 4, and component camera 5, and controls these devices. Further, control device 6 receives detection signals from light-receiving portion 824 and container detection sensor 87. **In** addition, control device 6 includes notifying section 61 for reporting various types of information to an operator. Examples of notifying section 61 include a notification lamp, a notification sound generator, a display device, and a portable terminal for notifying by communication.

Control device 6 determines that collecting container 81 is nearly full capacity based on the detection result of collecting state detection section 82, that is, when the detection signal received from light-receiving portion 824 indicates a light-blocking state and the light-blocking state continues for more than a predetermined time period. By relying on the determination using the predetermined time period, control device 6 is not affected by a temporary light-blocking state during which the unsuitable component falls, thereby preventing an erroneous determination. In addition, control device 6 determines that the removing operation for removing the unsuitable component from collecting container 81 is necessary when collecting container 81 is nearly full capacity. Notifying section 61 notifies the operator that the removing operation is necessary.

Even when a large unsuitable component straddles across opening 85, control device 6 can make the determination in the same manner as in the state of nearly full capacity. At this time, control device 6 further determines whether removing the large unsuitable component is necessary. In the first embodiment, it is necessary to remove each large unsuitable component.

In addition, control device 6 suspends the mounting operation when container detection sensor 87 is unable to detect collecting container 81. In this case, notifying section 61 notifies the operator that collecting container 81 is not set. When collecting container 81 is set and container detection sensor 87 detects collecting container 81, control device 6 restarts the mounting operation.

### 3. Operation and action of component mounting machine 1 and component collecting device 7

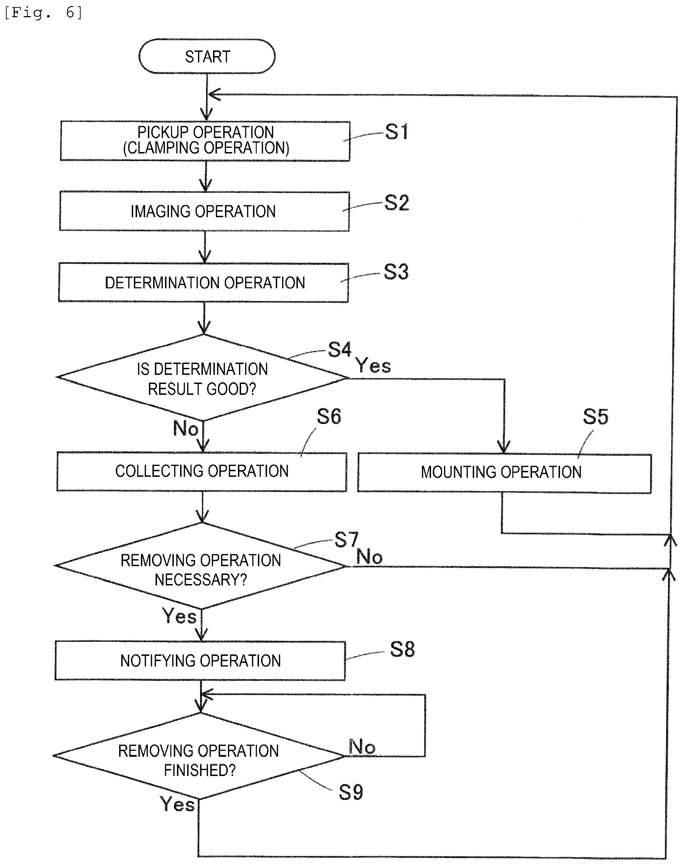

Next, the operation and action of component mounting machine 1 and component collecting device 7 will be described according to the control sequence of control device 6. In step S1 of the control sequence shown in Fig. 6, control device 6 controls the pickup operation or the clamping operation at the beginning of the mounting operation. As a result, component transfer device 4 moves mounting head 45 to a position above supply position 32 of feeder 3 so that the component is picked up with the suction nozzle. Alternatively, in the case of a large component, component transfer device 4 moves mounting head 45 to a position above tool station 48 and exchanges nozzle tool 46 with chuck tool 46A. Component transfer device 4 then sandwiches the large component from the tray device using the chuck.

In the next step, S2, control device 6 controls the imaging operation with component camera 5. With this configuration, component transfer device 4 moves mounting head 45 to a position above component camera 5. Component camera 5 captures an image of the component held by the suction nozzle or chuck and acquires image data. In the next step, S3, control device 6 or a separate image processing device performs image processing on the image data to determine whether the component is suitable for the mounting operation.

In the next step, S4, the execution of the control sequence of control device 6 branches off depending on the determination result. In step S5, if the determination result is good (suitable for the mounting operation), control device 6 controls the mounting operation. As a result, component transfer device 4 moves mounting head 45 to a position above board K. Further, component transfer device 4 executes the mounting operation by lowering the suction nozzle or the chuck and releasing the component. Thereafter, control device 6 returns the execution of the control sequence to step S1.

In the mounting operation, the component may not be released and may remain in the suction nozzle or the chuck. In this case, the component is an unsuitable component and control device 6 moves the execution of the control sequence to step S6 (not shown). In addition, since nozzle tool 46 has multiple suction nozzles, a portion of the multiple picked up components may be suitable for the mounting operation while the remainder of the multiple components may be unsuitable. In this case, after finishing the mounting operation of suitable components, control device 6 moves the execution of the control sequence for unsuitable components to step S6 (not shown).

**In** step S6, in which the determination result in step S4 is negative (i.e., not suitable for the mounting operation), control device 6 controls the collecting operation of the unsuitable component. As a result, component transfer device 4 moves mounting head 45 to a position above collecting container 81. **In** addition, component transfer device 4 transfers and releases the unsuitable component held by the suction nozzle or chuck to a position approximately above the center position of collecting container 81. Unsuitable components other than large components fall inside collecting container 81 and accumulate in a mountain shape around the center position.

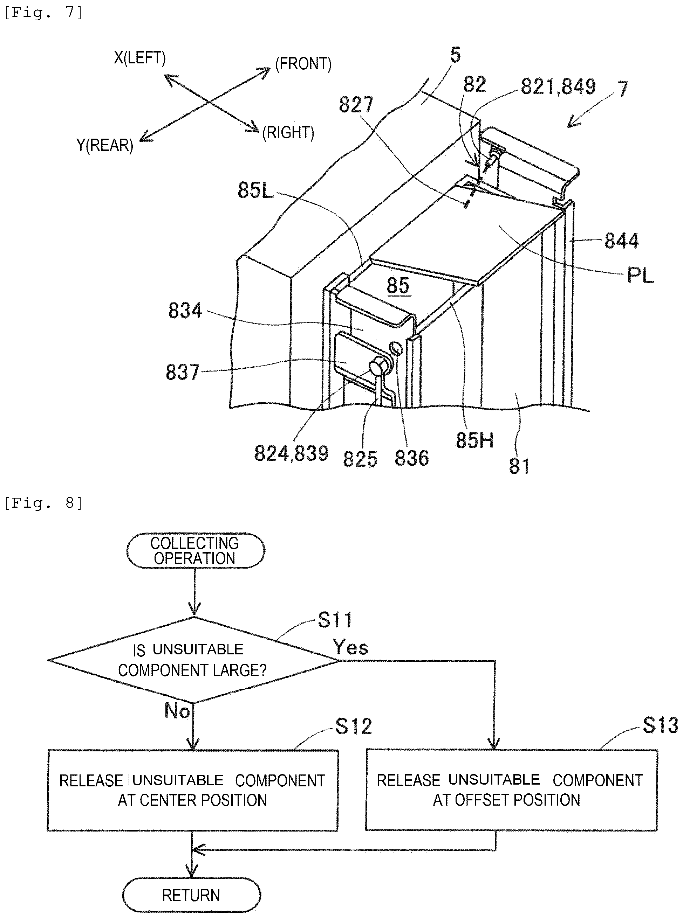

In addition, when large unsuitable component PL is transferred and released in a horizontal orientation, large unsuitable component PL straddles across opening 85 of collecting container 81 as shown in Fig. 7. Specifically, large unsuitable component PL straddles across opening 85 in an inclined orientation from the right high peripheral edge portion 85H to the left low peripheral edge portion 85L. In the state shown in Fig. 7, since the actual size of opening 85 becomes smaller, it is difficult to continue the collecting operation of unsuitable components.

In the next step, S7, control device 6 determines whether a removing operation is necessary. A removing operation is necessary in the following two cases. In either case, since the detection signal of the light-blocking state of collecting state detection section 82 continues for more than a predetermined amount of time, the determination by control device 6 is easy. Case 1) A state nearly full capacity in which the space in collecting container 81 is so small and detection light 827 is blocked by an unsuitable component near the top of the mountain-shaped stack. Case 2) As shown in Fig. 7, detection light 827 is blocked by large unsuitable component PL straddling across opening 85.

If the removing operation is not necessary, control device 6 returns the execution of the control sequence to step S1. If the removing operation is necessary, control device 6 advances the execution of the control sequence to step S8. In step S8, control device 6 notifies the operator that the removing operation is necessary and temporarily suspends the mounting operation. In the next step, S9, control device 6 waits for the removing operation to finish. When the removing operation is finished, control device 6 returns the execution of the control sequence to step S1 and restarts the mounting operation.

In component collecting device 7 of the first embodiment, collecting state detection section 82 spatially detects the collecting state of unsuitable components collected in collecting container 81. Accordingly, a state nearly full capacity in which the space in collecting container 81 is small can be reliably detected.

In addition, collecting state detection section 82 detects an orientation in which large unsuitable component PL straddles across opening 85 and outputs the same detection signal as the state close to full capacity. Accordingly, it is possible to collect large and expensive components to check their usability even when a small collecting container 81 is used. In addition, since large unsuitable component PL does not fall inside of collecting container 81, the possibility of damage is reduced.

If a collecting container having a large opening is employed, the size of the component collecting device is increased. As a result, the arrangement of devices such as tool station 48 and component camera 5 in the machine is constrained, thereby reducing the work efficiency. For example, when the position of component camera 5 is closer to the end, the moving time for mounting head 45 increases. In addition, the enlargement of the component collecting device may affect the size of component mounting device 1.

In addition, large unsuitable component PL can be reliably detected by a combination of a configuration in which large unsuitable component PL is straddling opening 85 in an inclined orientation and a configuration in which the optical axis of detection light 827 is inclined. The effect of detecting large unsuitable component PL is brought about even if only one of the configurations is employed. If neither configuration is employed, the horizontal optical axis of detection light 827 may pass through the upper side or the lower side of the unsuitable component extending in a horizontal orientation such that the light-blocking state does not occur.

### 4. Component mounting machine 1 of a second embodiment

Next, component mounting machine 1 of a second embodiment will be described mainly with respect to points different from the first embodiment. In the second embodiment, component collecting device 7 is the same as the first embodiment, but the collecting operation of the unsuitable component is different from the first embodiment. That is, when executing the control sequence shown in Fig. 6, control device 6 executes the control sequence shown in Fig. 8 for the collecting operation of step S6.

As described above, control device 6 controls the collecting operation of the unsuitable component. In step S11 of the control sequence in Fig. 8, control device 6 determines whether the unsuitable component is large. If the unsuitable component is not large in step S12, control device 6 transfers the unsuitable component held by the suction nozzle to a position above the approximate center position of collecting container 81 and releases the unsuitable component. The unsuitable component then falls into collecting container 81 and accumulates in a mountain shape around the center position. This collecting operation is the same as the first embodiment.

In step S13 when the unsuitable component is large, control device 6 controls component transfer device 4 so as to transfer the large unsuitable component, while keeping the large unsuitable component held by the chuck in a horizontal orientation, to a position above an offset position deviating from the center position of collecting container 81 and releases the large unsuitable component. In the second embodiment, the offset position is set to a position deviating to the right of the center position of collecting container 81.

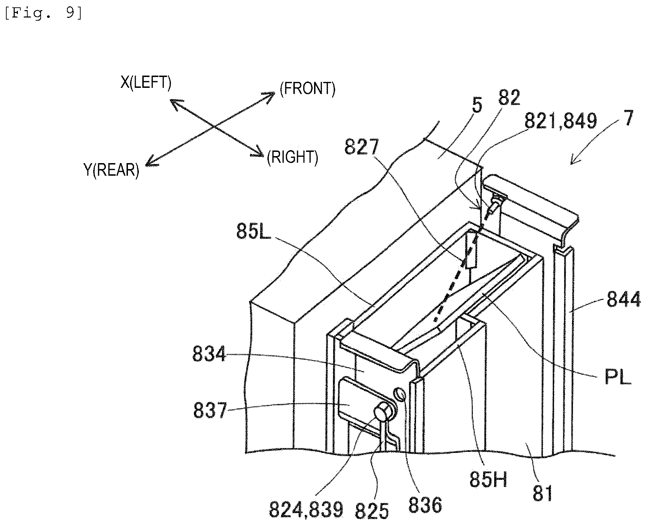

Then, as shown in Fig. 9, large unsuitable component PL comes in contact with high peripheral edge portion 85H on the right side of opening 85, changes to an inclined orientation without coming in contact with low peripheral edge portion 85L on the left, and drops inside collecting container 81. At this time, when the empty space of collecting container 81 is large, large unsuitable component PL that has fallen does not block the detection light. As a result, it is possible to continue the collecting operation of unsuitable components. Further, when the empty space of collecting container 81 is small, as shown in Fig. 9, large unsuitable component PL that has fallen blocks detection light 827 in an inclined orientation.

In the second embodiment, since large unsuitable component PL is tilted and then collected, collection container 81 can be downsized as compared with the related art in which large unsuitable component PL is dropped inside the collecting container in a horizontal orientation. In addition, unlike the first embodiment, since multiple large unsuitable components PL can be collectively collected, the number of removing operations can be reduced as compared with the first embodiment.

### 5. Applications and modifications of the embodiments

In the first embodiment, after collecting an unsuitable component (step S6), control device 6 checks the detection signal of collecting state detection section 82 (step S7), but may be made to constantly monitor the detection signal regardless of the collecting operation. Component collecting device 7 may be disposed at another position on base 10, or may be disposed at a position where any of feeders 3 is removed. In addition, the removing operation for removing an unsuitable component from collecting container 81 may be fully automated or semi-automated. In addition, the first and second embodiments can be applied or modified in various manners, as long as such modifications fall under the scope of the appended claims.

### Reference Signs List

1: Component mounting device, 3: Feeder, 4: Component transfer device, 5: Component camera, 6: Control device, 7: Component collecting device, 81: Collecting container, 82: Collecting state detection section, 821: Light-emitting portion, 824: Light-receiving portion, 827: Detection light, 83: Receiving member, 85: Opening, 85H: High peripheral edge portion, 85L: Low peripheral edge portion, 87: Container detection sensor, PL: Large unsuitable component

## Claims

1. A component collecting device (7), comprising:
a collecting container (81), being provided in a component mounting machine (1) for executing a mounting operation of components and having an opening (85) opened upward, which is configured to collect unsuitable components determined to be unsuitable for the mounting operation; and
a collecting state detection section (82) configured to spatially detect the collecting state of unsuitable components collected in the collecting container (81),
**characterized in that**
the collecting state detection section (82) is configured to detect a state in which the collecting container (81) is nearly full capacity with unsuitable components and a state in which a large unsuitable component (PL) straddles the opening (85) of the collecting container (81) wherein
the collecting state detection section (82) comprises a light emitting portion (821), disposed at one position in the vicinity of the opening (85) of the collecting container (81) to emit detection light (827) passing through the opening (85), and a light receiver (824), disposed at another position in the vicinity of the opening (85) to receive the detection light (827); and
the collecting state detection section (82) is a light-blocking detection sensor configured to detect a shading state in which the detection light (827) is blocked as a result of the unsuitable components being nearly full capacity; the optical axis of the detection light (827) is inclined with respect to at least one of the length direction, the width direction, and the height direction of the collecting container (81); and
the light-blocking detection sensor detects a light-blocking state in which the detection light (827) is blocked by a large unsuitable component (PL) straddling over the opening (85) of the collecting container (81).

2. The component collecting device of claim 1, wherein
the collecting container (81) has different heights at different portions (85H, 85L) of the peripheral edge of the opening (85), and
the light-blocking detection sensor is configured to detect a light-blocking state in which the detection light (827) is blocked by a large unsuitable component (PL) that staddles across the opening (85) of the collecting container (81) in an inclined orientation.

3. A component mounting machine (1), comprising:
the component collecting device (7) of claim 1 or 2;
a mounting executing device (4) configured to pick up, transfer, and release the component to perform the mounting operation; and
a control device (6) configured to determine whether the component is suitable for the mounting operation and control the mounting execution device (4) so that the mounting execution device (4) performs a collecting operation for collecting the unsuitable components in the collecting container (81).

4. The component mounting machine of claim 3, wherein the control device (6) is configured to determine whether a removing operation for removing the unsuitable component from the collecting container (81) is necessary based on the detection result of the collecting state detection section (82).

5. The component mounting device (1) of claim 3 or 4, wherein the large unsuitable component (PL) is a component large enough to straddle across the opening (85) of the collecting container (81),
the control device (6) is configured to control the mounting executing device (4) so as to transfer the large unsuitable component (PL) in a horizontal orientation to a position above an offset position deviating from the center of the opening (85) and release the large unsuitable component (PL), causing the large unsuitable component (PL) to tilt so the large unsuitable component (PL) abuts against one location (85H) of the peripheral edge of the opening (85) and falls inside the collection container (81).

## Patentansprüche

1. Eine Komponentenrückgewinnungsvorrichtung (7), umfassend:
einen Auffangbehälter (81), der in einer Komponentenmontagemaschine (1) zur Durchführung eines Komponentenmontagevorgangs vorgesehen ist und eine nach oben offene Öffnung (85) aufweist, die dazu konfiguriert ist, ungeeignete Komponenten aufzufangen, die als ungeeignet für den Montagevorgang ermittelt wurden; und
einen Auffangzustandserfassungsabschnitt (82), der so konfiguriert ist, dass er den Auffangzustand von ungeeigneten Komponenten, die im Auffangbehälter (81) aufgefangen wurden, räumlich erfasst,
**dadurch gekennzeichnet, dass**
der Auffangzustandserfassungsabschnitt (82) so konfiguriert ist, dass er einen Zustand erkennt, in dem der Auffangbehälter (81) fast vollständig mit ungeeigneten Komponenten gefüllt ist, und einen Zustand, in dem eine große ungeeignete Komponente (PL) die Öffnung (85) des Auffangbehälters (81) überspannt, wobei
der Auffangzustandserfassungsabschnitt (82) einen lichtemittierenden Abschnitt (821) umfasst, der an einer Position in der Nähe der Öffnung (85) des Auffangbehälters (81) angeordnet ist, um Detektionslicht (827) zu emittieren, das durch die Öffnung (85) hindurchgeht, und einen Lichtempfänger (824) umfasst, der an einer anderen Position in der Nähe der Öffnung (85) angeordnet ist, um das Detektionslicht (827) zu empfangen; und
der Sammelzustandserkennungsabschnitt (82) ein Lichtblockierungserkennungssensor ist, der so konfiguriert ist, dass er einen Verschattungszustand erkennt, in dem das Detektionslicht (827) aufgrund der fast vollständigen Füllung mit ungeeigneten Komponenten blockiert wird;
die optische Achse des Detektionslichts (827) in Bezug auf mindestens eine der Längsrichtung, Breitenrichtung und Höhenrichtung des Auffangbehälters (81) geneigt ist; und
der Lichtblockierungserkennungssensor einen Lichtblockierungszustand erkennt, in dem das Detektionslicht (827) durch eine große ungeeignete Komponente (PL) blockiert wird, die die Öffnung (85) des Auffangbehälters (81) überspannt.

2. Komponentenrückgewinnungsvorrichtung nach Anspruch 1, wobei
der Auffangbehälter (81) an verschiedenen Abschnitten (85H, 85L) des Umfangsrandes der Öffnung (85) unterschiedliche Höhen aufweist, und
der Lichtblockierungserkennungssensor so konfiguriert ist, dass er einen Lichtblockierungszustand erkennt, in dem das Detektionslicht (827) durch eine große ungeeignete Komponente (PL) blockiert wird, die in einer geneigten Ausrichtung die Öffnung (85) des Auffangbehälters (81) überspannt.

3. Komponentenmontagemaschine (1), umfassend:
die Komponentenrückgewinnungsvorrichtung (7) nach Anspruch 1 oder 2;
eine Montageausführungsvorrichtung (4), die so konfiguriert ist, dass sie die Komponente aufnimmt, transportiert und freigibt, um den Montagevorgang durchzuführen; und
eine Steuervorrichtung (6), die so konfiguriert ist, dass sie feststellt, ob die Komponente für den Montagevorgang geeignet ist, und die Montageausführungsvorrichtung (4) so steuert, dass die Montageausführungsvorrichtung (4) einen Sammelvorgang zum Sammeln der ungeeigneten Komponenten in dem Auffangbehälter (81) durchführt.

4. Komponentenmontagemaschine (1) nach Anspruch 3, wobei die Steuervorrichtung (6) so konfiguriert ist, dass sie auf der Grundlage des Erfassungsergebnisses des Auffangzustandserfassungsabschnitts (82) bestimmt, ob ein Entfernungsvorgang zum Entfernen der ungeeigneten Komponente aus dem Auffangbehälter (81) erforderlich ist.

5. Komponentenmontagemaschine (1) nach Anspruch 3 oder 4, wobei die große ungeeignete Komponente (PL) eine Komponente ist, die groß genug ist, um die Öffnung (85) des Auffangbehälters (81) zu überspannen,
die Steuervorrichtung (6) so konfiguriert ist, dass sie die Montageausführungsvorrichtung (4) so steuert, dass sie die große ungeeignete Komponente (PL) in horizontaler Ausrichtung zu einer Position über einer von der Mitte der Öffnung (85) abweichenden versetzten Position transportiert und die große ungeeignete Komponente (PL) freigibt, wodurch die große ungeeignete Komponente (PL) kippt, sodass die große ungeeignete Komponente (PL) an einer Stelle (85H) des Umfangsrandes der Öffnung (85) anstößt und in den Auffangbehälter (81) fällt.

## Revendications

1. Dispositif de collecte de composants (7), comprenant :
un conteneur de collecte (81) pourvu dans une machine de montage de composants (1) pour exécuter une opération de montage de composants et comportant une ouverture (85) ouverte vers le haut, qui est configuré pour collecter les composants inadaptés, déterminés comme étant inadaptés pour l'opération de montage ; et
une section de détection d'état de collecte (82) configurée pour détecter spatialement l'état de collecte des composants inadaptés collectés dans le conteneur de collecte (81),
**caractérisé en ce que**
la section de détection d'état de collecte (82) est configurée pour détecter un état où le conteneur de collecte (81) est presque plein jusqu'à sa capacité maximale de composants inadaptés, et un état dans lequel un gros composant inadapté (PL) chevauche l'ouverture (85) du conteneur de collecte (81), dans lequel
la section de détection d'état de collecte (82) comprend une portion émettrice de lumière (821), disposée à une position proche de l'ouverture (85) du conteneur de collecte (81) pour émettre une lumière de détection (827) qui traverse l'ouverture (85), et un récepteur de lumière (824), disposé à une autre position proche de l'ouverture (85) pour recevoir la lumière de détection (827) ;
la section de détection d'état de collecte (82) est un capteur de détection de blocage de la lumière configuré pour détecter un état d'ombrage dans lequel la lumière de détection (827) est bloquée du fait que les composants inadaptés occupent presque la capacité maximale ;
l'axe optique de la lumière de détection (827) est incliné par rapport à au moins une direction parmi la direction en longueur, la direction en largeur et la direction en hauteur du conteneur de collecte (81) ; et
le capteur de détection de blocage de la lumière détecte un état de blocage de la lumière dans lequel la lumière de détection (827) est bloquée par un grand composant inadapté (PL) qui chevauche l'ouverture (85) du conteneur de collecte (81).

2. Dispositif de collecte de composants selon la revendication 1, dans lequel
le conteneur de collecte (81) présente différentes hauteurs dans différents portions (85H, 85L) du bord périphérique de l'ouverture (85), et
le capteur de détection de blocage de la lumière est configuré pour détecter un état de blocage de la lumière dans lequel la lumière de détection (827) est bloquée par un grand composant inadapté (PL) qui chevauche l'ouverture (85) du conteneur de collecte (81) dans une orientation inclinée.

3. Machine de montage de composants (1), comprenant :
le dispositif de collecte de composants (7) selon la revendication 1 ou 2 ;
un dispositif d'exécution de montage (4) configuré pour saisir, transférer et libérer le composant afin d'effectuer l'opération de montage ; et
un dispositif de contrôle (6) configuré pour déterminer si le composant est adapté pour l'opération de montage et pour contrôler le dispositif d'exécution de montage (4) afin que le dispositif d'exécution de montage (4) effectue une opération de collecte pour collecter les composants inadaptés dans le conteneur de collecte (81).

4. Machine de montage de composants selon la revendication 3, dans laquelle le dispositif de contrôle (6) est configuré pour déterminer si une opération d'enlèvement destinée à enlever le composant inadapté du conteneur de collecte (81) est nécessaire sur la base du résultat de détection de la section de détection d'état de collecte (82).

5. Dispositif de montage de composants (1) selon la revendication 3 ou 4, dans lequel
le grand composant inadapté (PL) est un composant suffisamment grand pour chevaucher l'ouverture (85) du conteneur de collecte (81), et
le dispositif de contrôle (6) est configuré pour contrôler le dispositif d'exécution de montage (4) afin de transférer le grand composant inadapté (PL) dans une orientation horizontale vers une position située au-dessus d'une position décalée par rapport au centre de l'ouverture (85) et de libérer le grand composant inadapté (PL), ce qui provoque l'inclinaison du grand composant inadapté (PL) de sorte que le grand composant inadapté (PL) vienne buter contre un emplacement (85H) du bord périphérique de l'ouverture (85) et tombe à l'intérieur du conteneur de collecte (81).
